# EUROPEAN PATENT SPECIFICATION

(11) **EP 4 692 633 B1**
(45) Date of publication and mention of the grant of the patent: **19.08.2026**
(21) Application number: 25192042.7
(22) Date of filing: 28.07.2025
(51) Int. Cl.: F16P 3/08, B27B 5/00, G01P 3/44

(54) **DEVICE, SYSTEM AND METHOD FOR MONITORING AN INDUSTRIAL PLANT OR AN INDUSTRIAL MACHINE**
VORRICHTUNG, SYSTEM UND VERFAHREN ZUR ÜBERWACHUNG EINER INDUSTRIEANLAGE ODER EINER INDUSTRIEMASCHINE
DISPOSITIF, SYSTÈME ET PROCÉDÉ DE SURVEILLANCE D'UNE INSTALLATION INDUSTRIELLE OU D'UNE MACHINE INDUSTRIELLE

(30) Priority: 07.08.2024 IT 202400018589
(43) Date of publication of application: 11.02.2026
(73) Proprietor: Pizzato Elettrica S.r.l., 36063 Marostica (Vicenza) (IT)
(72) Inventor: PIZZATO, Giuseppe, 36063 MAROSTICA (VICENZA) (IT)
(74) Representative: Burchielli, Riccardo

(56) References cited:
- WO-A1-96/24798
- DE-B4- 102005 028 559
- DE-C2- 4 331 741
- US-A- 5 050 271
- US-A- 5 793 197

## Description

### TECHNICAL FIELD

The present invention relates to a safety device, safety system and related process for monitoring an industrial machine or plant comprising an electric motor connected to a load to be moved.

The device, system and process according to the invention find application, by way of example, in industrial machines or plants where it is necessary to monitor an electric motor and its load to determine whether the machine or plant is in a safe condition.

### STATE OF THE ART

There are known industrial applications where it is necessary to monitor the speed of an electric motor in a machine or plant.

A first example is the monitoring of the speed of the electric motor to determine whether it is at a standstill, that is, whether it has a speed of zero, in order to allow or deny a user access to a hazardous area in which the electric motor or the load it moves is located.

This case is typical of automatic or semi-automatic machines such as, for example, band saws, disk saws, etc., in which the electric motor is used to move loads (i.e., saw disks or belts) that have a high inertia and may still be in motion for a period of time after the motor is turned off.

To determine whether the electric motor is at a standstill, that is, whether it has zero speed, it is known to use safety devices, such as the one described in US6,049,284, which involve measuring the voltage across the steps of the electric motor when it is no longer energized and comparing the measured voltage with a reference voltage.

When the measured voltage is less than the reference voltage then the electric motor is considered stopped and the safety device signals that the machine is in a safe condition.

Such state of the art devices although appreciated and widely used have some drawbacks.

One drawback is that such known devices, in some cases, may signal that the electric motor is stopped even in cases where the load is still moving. Thus, the known device may allow access to the machine even if the load is found to be moving. In fact, in many applications the load is not directly connected to the shaft of the electric motor being monitored but is connected to it by transmission organs such as belts, chains, and others. In the event of failure of such transmission organs, the known devices would continue to allow access to the hazardous area where the electric motor is arranged with the load when the motor is stopped with the risk that the load, on the other hand, is still in motion.

This drawback may allow access to the hazardous area of the machine even when the load is not fully stopped creating a dangerous condition for the operator.

The relevant known art also includes patent document DE4331741C2.

Thus, one aim of the present invention is to make a safety device that is compact and easy to install and that allows both monitoring whether an electric motor is actually stopped when it is not energized and monitoring whether the load being moved by it is stopped.

Another aim of the present invention is to realize a safety device and procedure for increasing the safety level of a machine or system that comprises at least one electric motor.

### DESCRIPTION OF THE FIGURES

- Fig. 1 is a schematic representation of an industrial machine or plant associated with a safety device in accordance with the present invention;
- Figs. 2 through 6 are schematic representations of a safety device in accordance with respective embodiments of the present invention;
- Fig. 7 is a schematic representation of a part of a security device in accordance with a respective embodiment of the present invention;
- Fig. 8 is a block diagram of the process in accordance with one embodiment of the present invention.

### DESCRIPTION

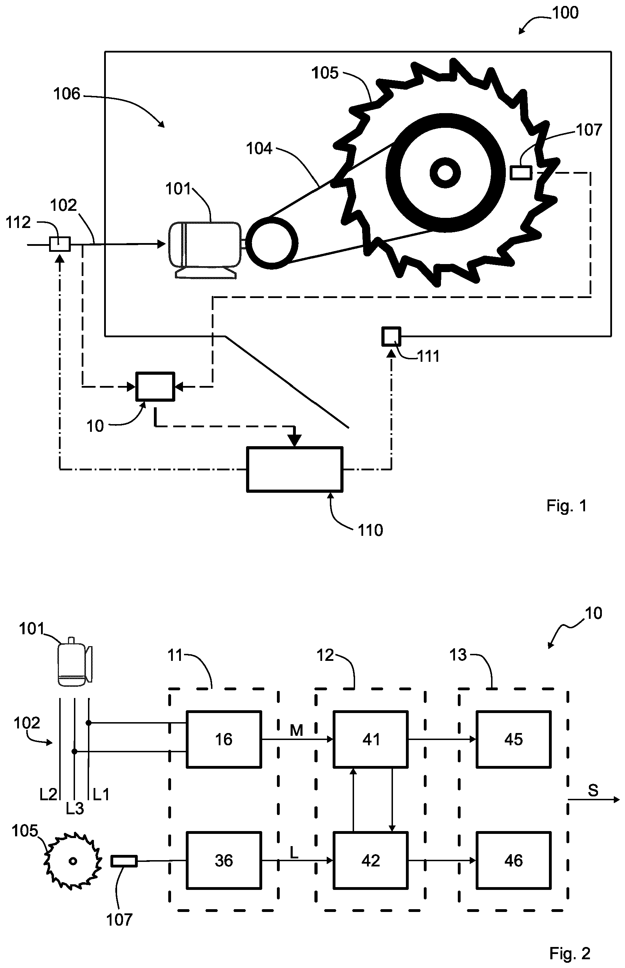

Referring to fig. 1, the safety device 10 according to the present invention is configured to be associated with an industrial machine or system 100 comprising at least one electric motor 101 powered by an electric network 102 and connected to a load 105 arranged in a dangerous zone 106 of the industrial machine or system 100.

The load 105 can be any organ set in motion by the electric motor 101, such as a disk saw, band saw, robotic arm, grinding wheel, and others, either directly or by means of transmission members 104 of any type, such as, for example, gear wheels, rack and pinion, chains, belts, ropes, springs, clutches, elastic couplings, viscous couplings, universal joints, crank connecting rod mechanisms, oscillating glyphs, cam or template mechanisms, and others.

Device 10 is configured to transmit a safety signal S related to the safety of machine or industrial plant 100 to activate a safety function of machine or industrial plant 100. Device 10 can be connected to a controller 110, such as a PLC of the machine or industrial plant 100, to transmit the safety signal S to the latter.

Exemplifying, the safety signal S can enable or inhibit the operation of the machine or industrial plant 100. Or the safety signal S may allow or inhibit an operator's access to the dangerous zone 106 in which the load 105 is arranged.

The device 10 of the present invention is configured to compare with each other a first physical quantity relating to the operation of the electric motor 101 and a second physical quantity relating to the state of the load 105.

The first physical quantity is selected from the voltage or frequency or both measured on the power supply line 102 of the electric motor 101.

The second physical quantity is selected from the speed, motion, state of motion or position of the load 105 or any other physical quantity such as temperature, pressure, torque associated with the state of the load 105.

It should be noted that in the following and in the claims when reference is made to the speed, motion, or position of the load 105, it is also understood to mean the speed or position of one or more of the transmission organs 104 interposed between the electric motor 101 and the load 105.

It should be noted that in the following and in the claims when reference is made to the speed, motion or position of the load 105 also means the speed or position of one or more motion transmission members 104 interposed between the electric motor 101 and the load 105.

The comparison is performed to detect any faults or abnormal situations associated with the motion of the load 105 or transmission members 104 and to activate a safety function of the machine or industrial plant 100 if faults or abnormal situations are detected.

In a first form of implementation, the first physical quantity is the voltage measured on the power supply line 102 and the second physical quantity is related to the state of the load 105 motion. For example, the second physical quantity is the speed of the load 105.

In this case, if a speed of the load 105 greater than zero, or greater than a minimum threshold, and a voltage on the power supply 100 that is zero, or less than a minimum threshold corresponding to a situation of a stopped electric motor 101 is detected, a fault is deduced.

In this case, the device 10, transmits a safety signal S to inhibit, or keep inhibited, access to the dangerous zone 106 where the load 105 is arranged, or transmits a signal to stop the industrial machine or plant 100.

Such a safety signal S may be transmitted to controller 110, which in turn commands an interlock 111 associated with access to the dangerous zone 106, or it may be transmitted directly to the interlock 111 or other general supervision system of the plant of which the machine is a part.

In other words, device 10 is configured to allow access to the dangerous zone 106 only if electric motor 101 and load 105 are simultaneously stopped.

Advantageously, the device 10 of the present invention inhibits or maintains inhibited access to the dangerous zone 106 in which the load 105 is arranged even if a zero voltage is detected or corresponding to a situation of the electric motor 101 stopped on the power supply line 102 despite the fact that the load 105 is still moving. In this way, device 10 makes it possible to increase the level of safety of the industrial machine or plant 100 since it inhibits or maintains inhibited access to the dangerous zone 106 even if there is a failure of the motion transmission members 104.

In another embodiment, the first physical quantity is the frequency measured on the power supply line 102 and the second physical quantity is the speed of the load 105. In this case, the comparison is performed to detect any abnormal situations of blocking, slippage, or partial damage of the motion transmission members104. In this case, if the frequency on the power supply 102 is greater than zero while the speed of the load 105 is zero a failure of the motion transmission members 104 or a blockage of the load 105 is deduced.

Alternatively, or additionally, the comparison is performed to verify that the relationship between the speed of the load 105 and the frequency detected on the power supply line 102 of the electric motor 101 meets predetermined parameters.

For example, the speed of load 105 may be proportional to the frequency detected on supply line 102 of electric motor 101.

Or, the relationship between the speed of load 105 and the frequency detected on supply line 102 of electric motor 101 may be defined by one or more predetermined mathematical functions of any type and stored by device 10.

In this case, if a relationship is detected between the speed of the load 105 and the frequency sensed on the power supply line 102 that does not correspond to the predetermined parameters, a fault is deduced, or excessive wear of the motion transmission members 104, or for example, excessive force applied to the load 105. In such cases, device 10 transmits a safety signal S to inhibit power supply to electric motor 101 if the fault or abnormal situation is deduced.

Such a safety signal S can be transmitted to the controller 110 which in turn controls a contactor 112 associated with the power supply line 102, or it can be transmitted directly to a contactor 112.

Advantageously, the device 10 of the present invention makes it possible to inhibit the power supply to the electric motor 101 even in cases where the latter appears to be operating properly despite the fact that there is a fault downstream of it, for example, at the load 105 or at the motion transmission members 104. Additionally, based on the set parameters it is possible to deduce excessive wear of the motion transmission members 104 such that a signal, for example a safe signal S or an unsafe signal, is sent from device 10 to controller 110 to indicate the need for maintenance to the machine 100.

With reference to the attached figures 2 to 6, device 10 is provided with a detection unit 11 configured to detect the first and second physical quantities, a processing unit 12 configured to compare the first and second physical quantities and process the safety signal S, and a signaling unit 13 configured to transmit the safety signal S in a fail-safe manner.

The signaling unit 13 can include fail-safe means of switching 45, 46 or a digital output, as will be described below.

The detection unit 11 is configured to be connected to the power supply line 102 of the electric motor 101 to detect the first physical quantity related to the operation of the electric motor 101 and to be connected to a sensor 107 configured to detect the second physical quantity related to the motion of the load 105.

Detection unit 11 comprises a first input channel 16 configured to be connected to power supply 102 of electric motor 101 in order to detect the first physical quantity related to the operation of electric motor 101.

Specifically, the first input channel 16 is configured to sense the voltage on the power supply 100 and transmit a motor signal M related to the first physical quantity to the processing unit 12.

The motor signal M can encode the absolute value of the sensed voltage (peak or peak-to-peak value) and/or the frequency value of the AC voltage sensed on the power supply line 102 or a value of current drawn by the electric motor 101.

For example, in the case where power supply line 102 of electric motor 101 is three-step type, the first input channel 16 can be connected in use to two of the three steps L1, L2, L3 of power supply line 102.

The device 10 also comprises, a second input channel 36 connected to the processing unit 11 and configured to be connected to the sensor 107 suitable to be associated with the load 105 and/or of the motion transmission members 104 interposed between the load 105 and the electric motor 101. The second input channel 36 is configured to detect via sensor 107 the second physical quantity.

The sensor 107 is configured to be positioned at the load 105 and/or motion transmission members 104 interposed between the load 105 and the electric motor 101 and to compute, or allow the processing unit 11 to compute, the speed of the load 105, the rotational speed of the load 105, or other physical quantity.

For example, sensor 107 is configured to detect the change in position of load 105 over time or its speed and to transmit to processing unit 11 a signal L related to the second physical quantity, hereafter called load signal L.

It should be noted that the load signal L may include information relating to the state of movement of load 105, the actual speed of load 105, or information relating to the change in position of load 105 over time.

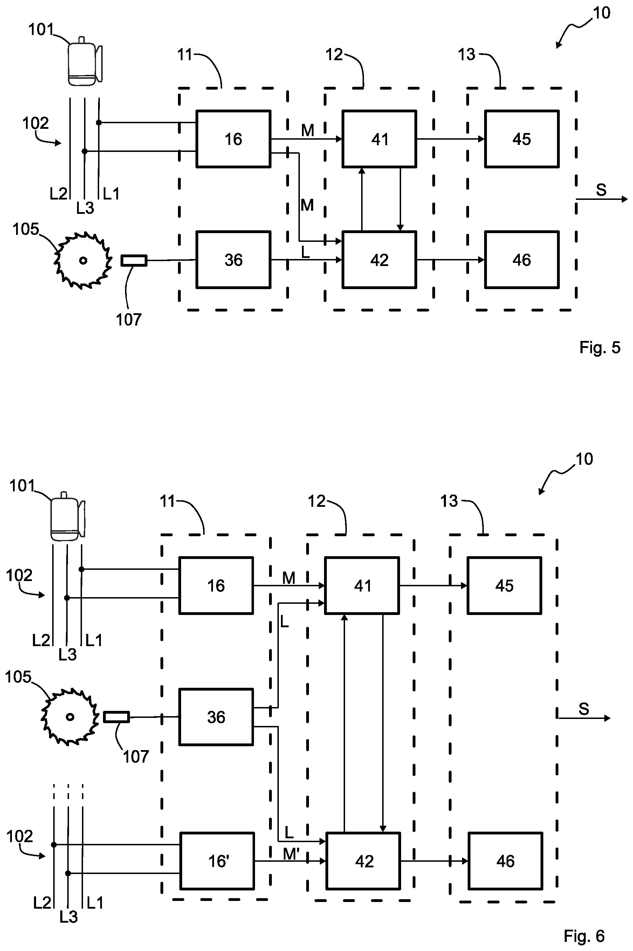

Exemplifying this, sensor 107 can be an inductive-type rotation sensor, a dynamo, an encoder, a pressure, temperature, torque sensor, or any other physical quantity. With reference to the embodiment form of Figure 6, the sensing unit 11 may further include a third input channel 16' also configured to be connected to the power supply line 102 of the electric motor 101 in order to detect the first physical quantity related to the operation of the electric motor 101.

In particular, the third input channel 16' is configured to sense the voltage on power supply line 102 and transmit to processing unit 12 a second motor signal M' correlated with said sensed voltage.

The second motor signal M' can encode the absolute value of the sensed voltage and/or the frequency value of the AC voltage sensed on the power supply 102 and/or a value of current drawn.

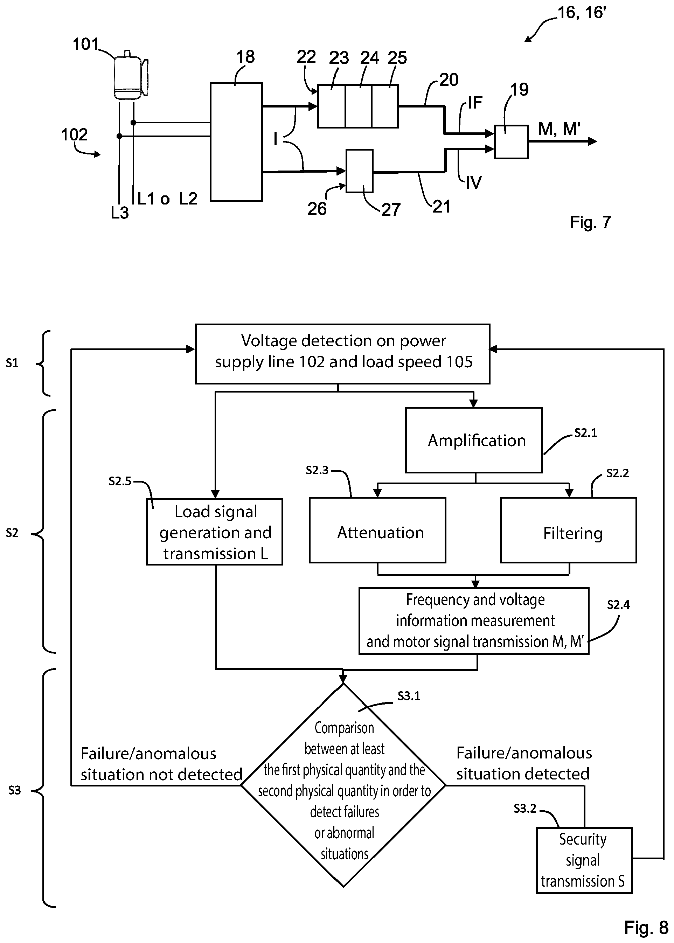

Preferably, with reference to figure 7, the first input channel 16 and the third input channel 16' are substantially the same and each comprises respective amplification means 18 and a respective measurement unit 19.

The amplification means 18 are configured to be connected to the power supply line 102 to scale the sensed voltage in order to transmit to the measurement unit 19 at least one intermediate voltage signal IV having a lower voltage value than the sensed voltage.

It should be noted that in this description and the appended claims, the term "amplification" also includes cases in which a signal is amplified by a value less than, or equal to, one and is therefore attenuated.

In the examples given here, the intermediate voltage signal IV is a square wave related to the time course of the measured voltage between two steps L1, L2, L3 of the power supply line 102 of the electric motor 101.

By way of example only, the means of amplification 18 include a differential amplifier, which is known by itself and will not be described in detail.

In addition, the means of amplification 18 are connected to the measurement unit 19 by a frequency line 20 and a voltage line 21.

The frequency line 20 advantageously comprises filter circuits 22 configured to provide the measurement unit 19 with an intermediate IF frequency signal filtered by noise and having a maximum acceptable value from the measurement unit 19. The filter circuits 22 comprise a first-order filter 23, a comparator with hysteresis 24, and a voltage divider 25 arranged in series, which are of a itself known type and which will not be described in detail.

The voltage line 21 comprises attenuation circuits 26 configured to provide the measurement unit 19 with an intermediate voltage IV signal having a maximum acceptable value from the measurement unit 19. In particular, the attenuation circuits 26 comprise a voltage divider 27, in itself known and which will not be described in detail.

The measurement unit 19 is configured to sample the intermediate frequency signal IF and the intermediate voltage signal IV. Furthermore, the measurement unit 19 is configured to perform a measurement of the intermediate frequency signal IF to obtain frequency information of the electric motor 101. In this case, this measurement involves measuring the period of the intermediate frequency signal IF and therefore its frequency.

It is specified that in this description and in the attached claims, the term "frequency" means a quantity related to the rotation speed of the electric motor 101.

Furthermore, the first measurement unit 19 is configured to perform a measurement of the intermediate voltage signal IV to obtain voltage information related to the measurable voltage on the power supply line 102.

In this case, the measuring unit 19 instantaneously measures the voltage of the intermediate voltage signal IV and the measured value corresponds to said voltage information.

The measurement unit 19 is configured to transmit to the processing unit 12 the aforementioned motor signal M, M' containing said frequency information and/or said voltage information, preferably in digital form corresponding to said first physical quantity.

Preferably, the processing unit 12 comprises a first computing unit 41 and a second computing unit 42 separate and connected to each other in a redundant manner.

Each computing unit 41 ,42 is configured to perform the comparison between the first physical quantity and the second physical quantity.

In one embodiment, each computing unit 41 ,42 is configured to compare the voltage information contained in the motor signal M with the speed of the load 105 detected via the load signal L. In this case, each computing unit 41 ,42 performs the comparison to verify that, if the voltage information corresponds to the condition of the electric motor 101 stopped, the speed of the load 105 is also zero.

In the event that this condition is not verified, the processing unit 12 is configured to generate a safety signal S to activate a safety function of the machine or industrial plant 100.

In this case, a safety signal S can be generated by controlling the switching means 45, 46 to switch them from the active state to the off state, or vice versa. Alternatively, the safety signal S can be transmitted in digital form to an external user via the digital output, signalling the fault condition.

Advantageously, in this way it is possible to activate a safety function of the machine or industrial plant with the safety signal S in the event that the electric motor 101 is stopped while the load 105 is moving, for example due to the failure of motion transmission members 104.

For example, in this case the activated safety function may be the inhibition of access to the dangerous zone 106 of the machine or industrial plant 100 and/or the reporting of the fault.

In a further embodiment each computing unit 41, 42 is configured to compare the frequency information contained in said motor signal M with the speed of the load 105 obtained from the load signal L.

In this case, the comparison is performed in order to detect any anomalous situations of blocking, slipping, damage to the motion transmission members 104 or others.

If each computing unit 41, 42 detects that the frequency on the power supply line 102 is greater than zero and the rotation speed of the load 105 is zero, then it generates a safety signal S to activate a safety function of the machine or industrial plant 100.

Instead, if each computing unit 41, 42 detects that the frequency on the power supply line 102 corresponds to a speed greater or less than the rotation speed of the load 105, it generates a safety signal S that indicates a slip situation.

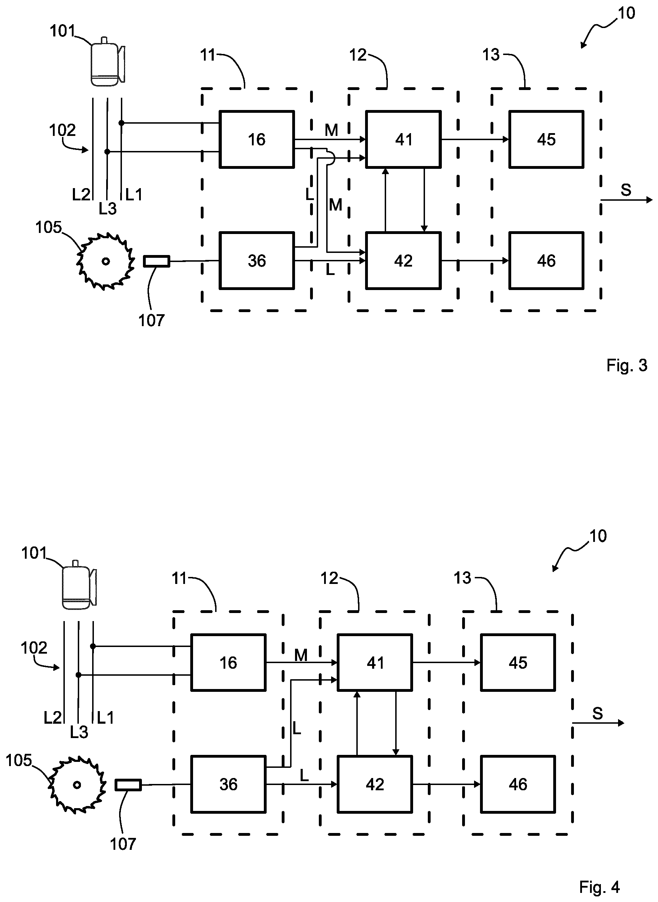

Or, if each computing unit 41, 42 detects that the relationship between the frequency on the power supply line 102 corresponds and the rotation speed of the load 105 does not respect predetermined parameters, for example mathematical functions stored in the computing unit 41, 42, it generates a safety signal S that indicates an anomalous situation. In this case, a safety signal S can be generated by controlling the switching means 45, 46 to make them pass from the active state to the inactive state, or vice versa. Alternatively, the safety signal S can be transmitted in digital form to an external user via the auxiliary digital output, possibly also signaling the extent of the detected anomaly. In an embodiment shown for example in figure 2, the first computing unit 41 is connected to the first input channel 16 and the second computing unit 42 is connected to the second input channel 36. In this case, the first computing unit 41 transmits the motor signal M to the second computing unit 42 and the second computing unit 42 transmits the load signal L to the first computing unit 41. In another embodiment shown for example in figure 3, the first computing unit 41 and the second computing unit 42 are connected to the first input channel 16 and to the second input channel 36.

In this case, the first computing unit 41 transmits the result of its comparison to the second computing unit 42 and the second computing unit 42 transmits the result of its comparison to the first computing unit 41.

Furthermore, each computing unit 41, 42 is configured to verify that the result of its comparison is consistent with the result of the comparison performed by the other computing unit 41, 42 to generate the safety signal S. In other possible embodiments, a computing unit 41 is connected to both input channels 16, 36 while the second computing unit 42 is exclusively connected to the first or second input channel 16, 36.

For example, in the embodiment of figure 5, the first computing unit 41 is connected to the first input channel 16 and the second computing unit 42 is connected to the first input channel 16 and to the second input channel 36.

In this case, the second computing unit 42 transmits the load signal L to the first computing unit 41.

Again, the first computing unit 41 transmits the result of its comparison to the second computing unit 42 and the second computing unit 42 transmits the result of its comparison to the first computing unit 41. Furthermore, each computing unit 41, 42 is configured to verify that the result of its comparison is consistent with the result of the comparison performed by the other computing unit 41, 42 to generate the safety signal S.

Or, in an embodiment schematically represented in figure 4, the first computing unit 41 is connected to the first input channel 16 and to the second input channel 36 and the second computing unit 42 is connected to the second input channel 36.

In this case, the first computing unit 41 transmits the motor signal M to the second computing unit 42.

Also in this case, the first computing unit 41 transmits the result of its comparison to the second computing unit 42 and the second computing unit 42 transmits the result of its comparison to the first computing unit 41. Furthermore, each computing unit 41, 42 is configured to verify that the result of its comparison is consistent with the result of the comparison performed by the other computing unit 41, 42 to generate the safety signal S.

In a further possible embodiment, represented in figure 6, the first computing unit 41 is connected to the first input channel 16 and to the second input channel 36 and the second computing unit 42 is connected to the second input channel 36 and to the third input channel 16'.

In this case, the first computing unit 41 is configured to compare the first physical quantity contained in the motor signal M with the second physical quantity contained in the load signal L and the second computing unit is configured to compare the first physical quantity contained in the second motor signal M' with the second physical quantity contained in the load signal L.

Also in this case, the first computing unit 41 transmits the result of its comparison to the second computing unit 42 and the second computing unit 42 transmits the result of its comparison to the first computing unit 41. Furthermore, each computing unit 41, 42 is configured to verify that the result of its comparison is consistent with the result of the comparison performed by the other computing unit 41, 42 to generate the safety signal S.

In other embodiments not shown, the first computing unit 41 is connected to the first input channel 16, the second computing unit 42 is connected to the third input channel 16' and one of the first computing unit 41 and the second computing unit 42 is connected to the second input channel 36 and transmits the load signal L to the other computing unit 41, 42.

The signaling unit 13 comprises switching means 45, 46, controlled by the processing unit 12 and suitable for switching from an active state to an inactive state and vice versa. In this case the safety signal S corresponds to the state, active or inactive, of the switching means 45, 46.

For example, the safety signal S that activates the safety function of the machine or industrial plant 100 that allows access to an operator inside the dangerous zone 106 may correspond to the active state of the switching means 45, 46.

Alternatively, the safety signal S that activates the safety function of the machine or industrial plant 100 that inhibits the power supply to the electric motor 101 may correspond to the inactive state of the switching means 45, 46.

In other embodiments, the signaling unit 13 comprises a digital output (not shown) connected to the processing unit 12 and configured to allow the transmission of signals in digital form, generated by the processing unit 12, to an external user. In this case, the safety signal S corresponds to the digital signals generated by the processing unit 12.

By way of example, the digital output may comprise a USB type connector, preferably a USB-C type, connected to the processing unit 12. Alternatively, or in addition, the digital output may comprise an industrial field bus or a communication bus, such as, for example, the IO - link bus connected to the processing unit 12.

The first and second computing units 41, 42 are configured to control the signaling unit 13 based on the comparison they perform between the first and second physical quantity.

For example, the signaling unit 13 may comprise a first OSSD (Output Signal Switching Device) type safety output 45 connected to the first computing unit 41 and a second OSSD type safety output 46 connected to the second computing unit 42. The first safety output 45 and the second safety output 46 may be independent of each other or connected in series.

Preferably, but not necessarily, the detection unit 11 and the processing unit 12 are obtained in a single printed circuit board and are separated from each other by an insulating barrier (not shown). Advantageously, the insulating barrier defines an electrical separation between the detection unit 11 and the processing unit 12. This allows to avoid any malfunctions or failures of the processing unit 12 caused by the high voltage present in the detection unit 11, in particular in the first and third input channels 16, 16', consequently increasing the safety level of the device 10 of the invention.

By way of example, the insulating barrier may comprise one or more photo-couplers, or opto-isolators, arranged between at least one input channel 16, 36, 16' and the processing unit 12.

The present invention also refers to a safety system comprising an electric motor 101 connected to a power line 102 and connected to a load 105. The safety system also comprises the aforementioned safety device 10 and the sensor 107.

Preferably the system also comprises a controller 110, for example a PLC, connected to said device 10 to receive a safety signal S and activate the safety function of the machine as a function of the control signal.

More specifically, the controller 110 may control an inverter (not shown in Fig. 1) which, in turn, controls the electric motor 101 and the safety device 10 communicates with the controller 110 and also directly controls two contactors located upstream, or downstream, of the inverter (also not shown) to interrupt the power supply to the electric motor 101 in the event of an unsafe situation.

Or, the device 10 transmits a safety signal S to prevent access to the dangerous zone 106 when the load 105 is in motion.

The present invention also refers to a safety procedure for an industrial machine or plant which includes a detection step S1, in which a first physical quantity relating to the operation of the electric motor 101 and a second physical quantity relating to the state of the load 105 are detected.

Here and in the following, the state of the load 105 means, for example, the movement of the load 105 including the condition in which the load 105 is stationary. During the detection step S1, the detection unit 11 detects the voltage on the power supply line 102 of the electric motor 101 and transmits to the processing unit 12 at least the motor signal M correlated to the detected voltage corresponding to the first physical quantity. Furthermore, during the detection step S1, the detection unit 11 detects, via the sensor 107, the speed, or the change in position, of the load 105 and transmits to the processing unit 12 the load signal L correlated to the state of the load 105 corresponding to the second physical quantity.

The method also includes a processing step S3 in which the processing unit 12 compares the first physical quantity and the second physical quantity and generates the safety signal S as a function of said comparison.

In step S1, the first input channel 16 detects the voltage on the power supply line 102 of the electric motor 101, while, in a subsequent preparation step S2, the first input channel 16 processes the voltage or frequency detected on the power supply line 102 and transmits at least one motor signal M to the processing unit 12.

Furthermore, the detection step S1 also provides for the sensor 107 to detect the second physical quantity relating to the state and/or movement of the load 105 and the preparation step S2 provides for the sensor 107 to generate and transmit the load signal L to the processing unit 12.

Optionally, in addition to the first input channel 16, a third input channel 16' can also be connected to the power supply line 102 of the electric motor 101 for the transmission of respective motor signals M, M' to respective computing units 41, 42 included in the processing unit 12.

Furthermore, the sensor 107 is configured to be connected to the second input channel 36 for transmission of the load signal L to the respective computing units 41, 42.

Optionally, for the transmission of the motor signal M, M' the preparation step S2 can include an amplification sub-step S2.1, according to which the amplification means 18 scale the detected voltage and transmit to the respective measuring unit 19 at least one respective intermediate voltage signal IV having a value lower than the detected value.

Furthermore, the preparation step S2 can also include a filtering sub-step S2.2, according to which each intermediate signal I is filtered by the respective filter circuits 22 to provide the respective measuring unit 19 with a respective intermediate frequency signal IF. In addition, the preparation step S2 can also include an attenuation sub-step S2.3, according to which each intermediate signal I is attenuated by the respective attenuation circuits 26 to provide the respective measuring unit 19 with a respective intermediate voltage signal IV, IV'.

The preparation step S2 also includes a measurement sub-step S2.4, according to which each measurement unit 19 performs a measurement of the respective intermediate frequency signal IF and the intermediate voltage signal IV to derive a frequency information and a voltage information. Furthermore, during the measurement sub-step S2.4, the measurement unit 19 transmits to the respective computing unit 41, 42 of the processing unit 12 a motor signal M, M' containing the respective frequency information and the respective voltage information.

Advantageously, the invention refers to a safety system for monitoring an industrial machine having an electric motor connected by transmission organs to a load arranged in a dangerous zone of the industrial machine and a safety device for monitoring the industrial machine.

Such a device may comprise or include all the features previously described.

From the above description, the features of the safety device and process for monitoring an electric motor, which are the subject matter of the present invention, and the advantages thereof are clear.

The invention thus conceived is susceptible to numerous modifications and variations, all of which fall within the scope of protection of the appended claims.

In addition, all details may be replaced by other technically equivalent elements; in practice, the materials used, as well as the contingent shapes and dimensions, may be varied according to contingent needs and the state of the art.

Where constructional features and techniques mentioned in the following claims are followed by reference numbers, these reference numbers have been affixed for the sole purpose of increasing the comprehensibility of the claims and, consequently, in no way constitute a limitation on the interpretation of each identified element.

## Claims

1. A safety device (10) for monitoring an industrial machine (100) having an electric motor (101) connected through motion transmission members (104) to a load (105) arranged in a dangerous zone (106) of said industrial machine (100) comprising:
- a detection unit (11) configured to detect both a first physical quantity related to the operation of said electric motor (101) and a second physical quantity related to the state of said load (105);
- at least one processing unit (12) configured to compare said first physical quantity and said second physical quantity in order to detect failures or anomalies and to generate a safety signal (S) on the basis of said comparison;
- a signalling unit (13) configured to securely transmit said safety signal (S) to activate or deactivate a safety function of said machine (100);
**characterised in that** said first physical quantity is selected between the voltage or frequency or current or a combination of them, measured on a power supply line (102) of said electric motor (101) and said second physical quantity is selected from the speed or position, or a combination of them, of said load (105) or of said motion transmission members (104) interposed between said load (105) and said electric motor (101).

2. Device (10) according to any one of the preceding claims **characterised in that** said detecting unit (1) comprises a first input channel (16) configured to be connected to a power supply line (102) of said electric motor (101) in order to detect the voltage on said power supply line (102) and to transmit at least motor signal (M) correlated to said sensed voltage to said processing unit (12) and a second input channel (36) configured to be connected to a sensor (107) associated with said load (105) in order to detect said second physical quantity and to transmit at least one load signal (L) correlated with said second physical quantity to said processing unit (12).

3. Device according to any one of the preceding claims **characterised in that** said signalling unit (13) comprises switching means (45, 46) controlled by said processing unit (12).

4. Device according to any one of the preceding claims **characterised in that** said processing unit (12) comprises a pair of computing units (41, 42) connected together in a redundant manner each of which is configured to compare said first physical quantity with said second physical quantity to generate said safety signal (S).

5. Device according to any one of the preceding claims **characterised in that** said safety function comprises inhibiting, or keeping inhibited, the access to said dangerous zone (106) and/or inhibiting the power supply of said electric motor (101) and/or generating a stop command of said machine (100) and/or inhibiting the start of said machine.

6. A safety system comprising an electric motor (101), a power supply line (102) of said electric motor (101), a load (105) moved by said electric motor (101), a device (10) as according to any one of the preceding claims and a sensor (107) connected to said device (10) and associated with said load (105) for detecting the speed or position or other physical quantity of said load (105).

7. A safety process for an industrial machine comprising an electric motor (101) connected through motion transmission members (104) to a load (105) and supplied by a power supply line (102) wherein said process comprises at least the following steps
- a detection step (S1) of a first physical quantity relating to the operation of said electric motor (101) and of a second physical quantity relating to the movement of said load (105);
- a processing step (S3), wherein said first physical quantity is compared with said second physical quantity in order to detect failures or anomalies and a safety signal (S) is generated on the basis of said comparison in order to activate a safety function of said industrial machine (100);
**characterized in that** said first physical quantity is selected between the voltage or frequency measured on said power supply line (102) of said electric motor (101) and said second physical quantity is selected between the speed or the position of said load (105) or of said motion transmission members (104) interposed between said load (105) and said electric motor (101).

8. Process according to claim 7 **characterized in that** said safety function inhibits, or keeps inhibited the access to said dangerous zone (106) and/or inhibits the power supply of said electric motor (101) and/or generates a stop command of said machine (100) and/or inhibits the start of said machine (100).

## Patentansprüche

1. Eine Schutzeinrichtung (10) zur Überwachung einer Industriemaschine (100) mit einem Elektromotor (101), der über Bewegungstransmissionselemente (104) mit einer Last (105) verbunden ist, die in einem Gefahrenbereich (106) der genannten Industriemaschine (100) angeordnet ist, umfassend:
- eine Erfassungseinheit (11), die so konfiguriert ist, dass sie sowohl eine erste physikalische Größe, die mit dem Betrieb des genannten Elektromotors (101) zusammenhängt, als auch eine zweite physikalische Größe, die mit dem Zustand der genannten Last (105) zusammenhängt, erfasst;
- mindestens eine Verarbeitungseinheit (12), die so konfiguriert ist, dass sie die genannte erste physikalische Größe und die genannte zweite physikalische Größe vergleicht, um Fehler oder Anomalien zu erkennen und auf Grundlage dieses Vergleichs ein Sicherheitssignal (S) zu erzeugen;
- eine Signaleinheit (13), die so konfiguriert ist, dass sie das genannte Sicherheitssignal (S) sicher überträgt, um eine Sicherheitsfunktion der genannten Maschine (100) zu aktivieren oder zu deaktivieren;
**dadurch gekennzeichnet, dass** die genannte erste physikalische Größe zwischen Spannung oder Frequenz oder Strom oder einer Kombination davon ausgewählt ist, gemessen an einer Stromversorgungsleitung (102) des genannten Elektromotors (101), und die genannte zweite physikalische Größe aus der Geschwindigkeit oder Position oder einer Kombination davon der genannten Last (105) oder der genannten Bewegungstransmissionselemente (104), die zwischen der genannten Last (105) und dem genannten Elektromotor (101) angeordnet sind, ausgewählt ist.

2. Einrichtung (10) nach einem der vorhergehenden Ansprüche, **dadurch gekennzeichnet, dass** die genannte Erfassungseinheit (1) einen ersten Eingangskanal (16) umfasst, der so konfiguriert ist, dass er mit einer Stromversorgungsleitung (102) des genannten Elektromotors (101) verbunden wird, um die Spannung an der genannten Stromversorgungsleitung (102) zu erfassen und mindestens ein Motorsignal (M), das mit der erfassten Spannung korreliert, an die genannte Verarbeitungseinheit (12) zu übertragen, und einen zweiten Eingangskanal (36), der so konfiguriert ist, dass er mit einem Sensor (107) verbunden wird, welcher der genannten Last (105) zugeordnet ist, um die genannte zweite physikalische Größe zu erfassen und mindestens ein Lastsignal (L), das mit der genannten zweiten physikalischen Größe korreliert, an die genannte Verarbeitungseinheit (12) zu übertragen.

3. Einrichtung nach einem der vorhergehenden Ansprüche, **dadurch gekennzeichnet, dass** die genannte Signaleinheit (13) Schaltmittel (45, 46) umfasst, die von der genannten Verarbeitungseinheit (12) gesteuert werden.

4. Einrichtung nach einem der vorhergehenden Ansprüche, **dadurch gekennzeichnet, dass** die genannte Verarbeitungseinheit (12) ein Paar von Recheneinheiten (41, 42) umfasst, die redundant miteinander verbunden sind, von denen jede so konfiguriert ist, dass sie die genannte erste physikalische Größe mit der genannten zweiten physikalischen Größe vergleicht, um das genannte Sicherheitssignal (S) zu erzeugen.

5. Einrichtung nach einem der vorhergehenden Ansprüche, **dadurch gekennzeichnet, dass** die genannte Sicherheitsfunktion das Sperren oder Aufrechterhalten der Sperrung des Zugangs zu dem genannten Gefahrenbereich (106) und/oder das Sperren der Stromversorgung des genannten Elektromotors (101) und/oder das Erzeugen eines Stoppbefehls für die genannte Maschine (100) und/oder das Sperren des Starts der genannten Maschine umfasst.

6. Ein Sicherheitssystem, das einen Elektromotor (101), eine Stromversorgungsleitung (102) des genannten Elektromotors (101), eine von dem genannten Elektromotor (101) bewegte Last (105), ein Gerät (10) gemäß einem der vorhergehenden Ansprüche und einen mit dem genannten Gerät (10) verbundenen Sensor (107) umfasst, welcher der genannten Last (105) zugeordnet ist, um die Geschwindigkeit oder Position oder eine andere physikalische Größe der genannten Last (105) zu erfassen.

7. Ein Sicherheitsverfahren für eine Industriemaschine, die einen Elektromotor (101) umfasst, der über Bewegungstransmissionselemente (104) mit einer Last (105) verbunden ist und von einer Stromversorgungsleitung (102) gespeist wird, wobei das Verfahren mindestens die folgenden Schritte umfasst
- einen Erfassungsschritt (S1) einer ersten physikalischen Größe, die sich auf den Betrieb des genannten Elektromotors (101) bezieht, und einer zweiten physikalischen Größe, die sich auf die Bewegung der genannten Last (105) bezieht;
- einen Verarbeitungsschritt (S3), in dem die genannte erste physikalische Größe mit der genannten zweiten physikalischen Größe verglichen wird, um Fehler oder Anomalien zu erkennen, und ein Sicherheitssignal (S) auf Grundlage dieses Vergleichs erzeugt wird, um eine Sicherheitsfunktion der genannten Industriemaschine (100) zu aktivieren;
**dadurch gekennzeichnet, dass** die genannte erste physikalische Größe zwischen der an der genannten Stromversorgungsleitung (102) des genannten Elektromotors (101) gemessenen Spannung oder Frequenz ausgewählt ist und die genannte zweite physikalische Größe zwischen der Geschwindigkeit oder der Position der genannten Last (105) oder der genannten Bewegungstransmissionselemente (104), die zwischen der genannten Last (105) und dem genannten Elektromotor (101) angeordnet sind, ausgewählt ist.

8. Verfahren nach Anspruch 7, **dadurch gekennzeichnet, dass** die genannte Sicherheitsfunktion den Zugang zu dem genannten Gefahrenbereich (106) sperrt oder gesperrt hält und/oder die Stromversorgung des genannten Elektromotors (101) sperrt und/oder einen Stoppbefehl für die genannte Maschine (100) erzeugt und/oder den Start der genannten Maschine (100) sperrt.

## Revendications

1. Un dispositif de sécurité (10) pour la surveillance d'une machine industrielle (100) comportant un moteur électrique (101) connecté par des éléments de transmission de mouvement (104) à une charge (105) disposée dans une zone dangereuse (106) de ladite machine industrielle (100) comprenant:
- une unité de détection (11) configurée pour détecter à la fois une première grandeur physique liée au fonctionnement dudit moteur électrique (101) et une seconde grandeur physique liée à l'état dudit charge (105) ;
- au moins une unité de traitement (12) configurée pour comparer ladite première grandeur physique et ladite seconde grandeur physique afin de détecter des défaillances ou anomalies et pour générer un signal de sécurité (S) sur la base de ladite comparaison;
- une unité de signalisation (13) configurée pour transmettre de manière sécurisée ledit signal de sécurité (S) afin d'activer ou désactiver une fonction de sécurité de ladite machine (100);
**caractérisé en ce que** ladite première grandeur physique est choisie parmi la tension ou la fréquence ou le courant ou une combinaison de ceux-ci, mesurée sur une ligne d'alimentation (102) dudit moteur électrique (101) et ladite seconde grandeur physique est choisie parmi la vitesse ou la position, ou une combinaison de celles-ci, de ladite charge (105) ou desdits éléments de transmission de mouvement (104) interposés entre ladite charge (105) et ledit moteur électrique (101).

2. Dispositif (10) selon l'une quelconque des revendications précédentes **caractérisé en ce que** ladite unité de détection (1) comprend un premier canal d'entrée (16) configuré pour être connecté à une ligne d'alimentation (102) dudit moteur électrique (101) afin de détecter la tension sur ladite ligne d'alimentation (102) et de transmettre au moins un signal moteur (M) corrélé à ladite tension détectée à ladite unité de traitement (12) et un second canal d'entrée (36) configuré pour être connecté à un capteur (107) associé à ladite charge (105) afin de détecter ladite seconde grandeur physique et de transmettre au moins un signal charge (L) corrélé à ladite seconde grandeur physique à ladite unité de traitement (12).

3. Dispositif selon l'une quelconque des revendications précédentes **caractérisé en ce que** ladite unité de signalisation (13) comprend des moyens de commutation (45, 46) commandés par ladite unité de traitement (12).

4. Dispositif selon l'une quelconque des revendications précédentes **caractérisé en ce que** ladite unité de traitement (12) comprend une paire d'unités de calcul (41, 42) connectées ensemble de manière redondante, chacune étant configurée pour comparer ladite première grandeur physique avec ladite seconde grandeur physique afin de générer ledit signal de sécurité (S).

5. Dispositif selon l'une quelconque des revendications précédentes **caractérisé en ce que** ladite fonction de sécurité comprend l'inhibition, ou le maintien inhibé, de l'accès à ladite zone dangereuse (106) et/ou l'inhibition de l'alimentation électrique dudit moteur électrique (101) et/ou la génération d'une commande d'arrêt de ladite machine (100) et/ou l'inhibition du démarrage de ladite machine.

6. Un système de sécurité comprenant un moteur électrique (101), une ligne d'alimentation (102) dudit moteur électrique (101), une charge (105) déplacée par ledit moteur électrique (101), un dispositif (10) selon l'une quelconque des revendications précédentes et un capteur (107) connecté audit dispositif (10) et associé à ladite charge (105) pour détecter la vitesse ou la position ou une autre grandeur physique de ladite charge (105).

7. Un procédé de sécurité pour une machine industrielle comprenant un moteur électrique (101) connecté par des éléments de transmission de mouvement (104) à une charge (105) et alimenté par une ligne d'alimentation (102) dans lequel ledit procédé comprend au moins les étapes suivantes
- une étape de détection (S1) d'une première grandeur physique relative au fonctionnement dudit moteur électrique (101) et d'une seconde grandeur physique relative au mouvement de ladite charge (105);
- une étape de traitement (S3), dans laquelle ladite première grandeur physique est comparée à ladite seconde grandeur physique afin de détecter des défaillances ou anomalies et un signal de sécurité (S) est généré sur la base de ladite comparaison afin d'activer une fonction de sécurité de ladite machine industrielle (100);
**caractérisé en ce que** ladite première grandeur physique est choisie parmi la tension ou la fréquence mesurée sur ladite ligne d'alimentation (102) dudit moteur électrique (101) et ladite seconde grandeur physique est choisie parmi la vitesse ou la position de ladite charge (105) ou desdits éléments de transmission de mouvement (104) interposés entre ladite charge (105) et ledit moteur électrique (101).

8. Procédé selon la revendication 7 **caractérisé en ce que** ladite fonction de sécurité inhibe, ou maintient inhibé, l'accès à ladite zone dangereuse (106) et/ou inhibe l'alimentation dudit moteur électrique (101) et/ou génère une commande d'arrêt de ladite machine (100) et/ou inhibe le démarrage de ladite machine (100).
